# EUROPÄISCHE PATENTANMELDUNG

(11) **EP 0 971 571 A2**
(43) Veröffentlichungstag der Anmeldung: **12.01.2000**
(21) Anmeldenummer: 99112236.7
(22) Anmeldetag: 25.06.1999
(51) Int. Cl.: H05K 3/46

(54) **Verfahren zur Herstellung eines Multilayers**

(30) Priorität: 09.07.1998 DE 19830628
(71) Anmelder: Maschinenfabrik Lauffer GmbH & Co. KG, 72160 Horb (DE); Hewlett-Packard Company, Palo Alto, California 94304 (US)
(72) Erfinder: Dippon, Siegfried, 75391 Gechingen (DE); Stenker, Jens, 71143 Aidlingen (DE); Plocher, Werner, 72160 Horb (DE)
(74) Vertreter: Späth, Dieter, Dipl.-Ing.

(57) **Zusammenfassung**

Die Erfindung betrifft ein Verfahren zur Herstellung einers Multilayers (11). Die Erfindung schlägt vor, Innenlagen (10) des Multilayers (11) zum Fixieren aneinander örtlich begrenzt an mehreren Stellen ihrer Stirnflächen mit einem Heizstempel (20) oder durch Löcher (32) mit einem Heizstift (36) zu erwärmen und dadurch an einigen Stellen miteinander zu verkleben. Das erfindungsgemäße Verfahren hat den Vorteil, daß alle Innenlagen (10), insbesondere auch innere Innenlagen (10), gleich stark erwärmt und auf diese Weise qualitativ gut fixiert werden. Nach der Fixierung der Innenlagen (10) werden diese in an sich bekannter Weise in einem Preßwerkzeug unter Temperaturbeaufschlagung zum Multilayer (11) laminiert.

## Beschreibung

Die Erfindung betrifft ein Verfahren zur Herstellung eines Multilayers (Mehrschicht-Leiterplatte) mit den Merkmalen des Oberbegriffs des Anspruchs 1.

Zur Herstellung eines Multilayers werden Innenlagen aufeinandergelegt (gestapelt) und registriert, d. h. so zueinander ausgerichtet, daß die Leiterbahnen der Innenlagen in einer vorgesehenen Stellung zueinander zu liegen kommen. Das Registrieren der Innenlagen kann mit Hilfe in die Innenlagen eingebrachter Registrierlöcher erfolgen, die mit durchgesteckten Registrierstiften (Pins) deckungsgleich zueinander ausgerichtet werden. Ein optisches Registrieren der Innenlagen mit Hilfe von Videokameras ist ebenfalls bekannt. Die registrierten Innenlagen werden in einem Preßwerkzeug durch Temperatur- und Druckbeaufschlagung laminiert, d. h. vollflächig stoffschlüssig zum herzustellenden Multilayer verbunden. Dazu müssen jedoch die die Innenlagen zueinander ausrichtenden Registrierstifte im Preßwerkzeug vorhanden sein. Weiterer Nachteil des Ausrichtens der Innenlagen mit Registrierstiften ist das Verkleben der Innenlagen mit den Registrierstiften und ein Klebstoffaustritt (Harz) an den Registrierlöchern der Innenlagen (Verschmutzung der Oberfläche durch Harzpartikel). Das Preßwerkzeug bzw. in das Preßwerkzeug eingelegte Trennbleche müssen nach dem Laminieren von Klebstoff gereinigten werden.

Eine andere Möglichkeit ist es, die registrierten Innenlagen zu fixieren, d. h. zunächst örtlich begrenzt an einigen Stellen miteinander zu verbinden und anschließend in einem Preßwerkzeug unter Beaufschlagung mit Temperatur und Druck zu laminieren. Das Fixieren erfolgt beispielsweise durch Bohren und Nieten oder auch durch punktuelle Temperaturbeaufschlagung (Stoffschluß) der Innenlagen mittels an Ober- und Unterseite des Multilayers aufgesetzter Heizstifte. Während des Fixierens verbleiben die durch die Registrierlöcher der Innenlagen gesteckten Registrierstifte, die die Innenlagen zueinander ausrichten, in den Innenlagen, um ein Verschieben der Innenlagen gegeneinander zu vermeiden. Vor dem Laminieren der Innenlagen im Preßwerkzeug können die Registrierstifte aus den Innenlagen herausgezogen werden, da die Fixierung ein Verschieben der registrierten Innenlagen verhindert. Das Laminieren durch Stoffschluß erfolgt im Vakuum.

Das Nieten der Innenlagen hat, neben dem hierfür notwendigen Aufwand, den Nachteil, daß die Nieten an Ober- und Unterseite des Multilayers überstehen und beim anschließenden Laminieren im Preßwerkzeug störend im Weg sind. Hinzu kommt, daß die Nieten beim Pressen gestaucht werden, wodurch sich die Innenlagen trotz bzw. gerade wegen der eingesetzten Nieten gegeneinander verschieben können.

Das Fixieren der Innenlagen durch punktuelle Temperatur- und Druckbeaufschlagung hat den Nachteil, daß außenliegende Innenlagen des Multilayers stark erwärmt werden, wodurch es zu Zerstörungen, d. h. Verbrennen von Harz, kommen kann, wogegen innere Innenlagen aufgrund der thermischen Isolationswirkung der Innenlagen nur unzureichend erwärmt werden, wodurch die inneren Innenlagen schlecht oder überhaupt nicht miteinander verbunden werden. Diese Art des Fixierens ist auf eine geringe Anzahl von Innenlagen beschränkt.

Der Erfindung liegt die Aufgabe zugrunde, ein vereinfachtes Verfahren zur Herstellung eines Multilayers vorzuschlagen.

Diese Aufgabe wird erfindungsgemäß durch die Merkmale des Anspruchs 1 gelöst. Beim erfindungsgemäßen Verfahren werden die aufeinander gelegten Innenlagen in an sich bekannter Weise beispielsweise mit Registrierstiften, die durch Registrierlöcher in den Innenlagen gesteckt werden, registriert. Zum Fixieren werden die Innenlagen an über die gesamte Dicke des Multilayers durchgehenden Freiflächen mit Temperatur beaufschlagt. Das bedeutet, daß beispielsweise ein Heizwerkzeug beim Fixieren an allen Innenlagen des Multilayers zugleich anliegt. Die Freiflächen können Stellen an Stirnseiten des Multilayers oder Lochwandungen von durch den Multilayer durchgehenden Lochungen sein. Die Erfindung hat den Vorteil, daß jede Innenlage unmittelbar mit Temperatur beaufschlagt und somit jede der Innenlagen gleich stark erwärmt wird. Dadurch wird eine Überhitzung insbesondere außenliegender Innenlagen ebenso wie eine unzureichende Erwärmung innerer Innenlagen vermieden, die für das Fixieren gewünschte Temperatur läßt sich für jede Innenlage genau einstellen. Nach dem Fixieren werden die zur Ausrichtung der Innenlagen verwendeten Registrierstifte herausgezogen und die Innenlagen in einem Preßwerkzeug im Vakuum unter Temperatur- und/oder Druckbeaufschlagung zu einem Multilayer laminiert.

Zur Schaffung einer qualitativ guten Fixierung werden die Innenlagen bei einer Ausgestaltung des erfindungsgemäßen Verfahrens während der Fixierung zumindest im Bereich der Fixierstellen aneinander gedrückt.

Zur elektrischen Isolierung der Leiterbahnen zweier Innenlagen voneinander werden Isolationsschichten zwischen den Innenlagen angebracht. Die Isolationsschicht besteht insbesondere aus einem Prepreg, einer Isolationsfolie, die einen Klebstoff (Harz) zum Verbinden der Innenlagen aufweist. Der Klebstoff ist beispielsweise ein Schmelzkleber, der bei Temperatur- und/oder Druckbeaufschlagung aufschmilzt und anschließend wieder aushärtet und die Innenlagen durch Stoffschluß miteinander verbindet. Der Stoffschluß erfolgt beispielsweise durch Polymerisation, also ein Schweißen oder Kleben. Auch kann ein Klebstoff oder ein mit Klebstoff getränktes Gewebe als Isolationsschicht auf die Innenlagen aufgebracht werden.

Als Freifläche zur örtlich begrenzten Temperaturbeaufschlagung der Innenlagen beim Fixieren kann eine oder können mehrere Stellen an Stirnflächen des Multilayers verwendet werden. Um eine bündige Freifläche zu gewährleisten, wird diese bei einer Ausgestaltung des erfindungsgemäßen Verfahrens nach dem Registrieren der Innenlagen in einem Trennverfahren hergestellt. Dazu kann an einer oder mehreren Stellen von Stirnflächen des Multilayers gefräst werden. Auch können ein oder mehrere durch alle Innenlagen des Multilayers durchgehende Löcher beispielsweise gebohrt oder gestanzt werden, deren Lochwandungen die Freifläche bilden. Diese Ausgestaltung der Erfindung hat den Vorteil, daß eine ohne Stufen durchgehende Freifläche geschaffen wird, auch wenn Ränder der registrierten Innenlagen nicht deckungsgleich sind. Die stufenlos durchgehende Freifläche hat den Vorteil, daß eine gleichmäßige Erwärmung jeder Innenlage sichergestellt ist.

Nach dem Fixieren der Innenlagen werden diese in einer Presse vollflächig mit Druck und/oder Temperatur beaufschlagt und dadurch laminiert. Das Laminieren wird im Vakuum durchgeführt. Die Fixierung verhindert, daß sich sie registrierten Innenlagen während des Laminierens gegeneinander Verschieben, so daß sich die Leiterbahnen der laminierten Innenlagen in ihrer vorgesehener Lage zueinander befinden. Auf eine Ober- und/oder eine Unterseite des hergestellten Multilayers kann nach Aufbringen eines weiteren Prepregs eine weitere elektrisch leitende Schicht, eine sog. Außenlage, aufgebracht werden. Aus der elektrisch leitenden Schicht werden in an sich bekannter Weise durch ein Ätzverfahren auf fotochemischem Weg Leiterbahnen hergestellt. Diese Ausgestaltung der Erfindung hat den Vorteil, daß Leiterbahnen in einer oder mehreren zusätzlichen Ebenen auf der Ober- und/oder der Unterseite des Multilayers angebracht werden können.

Die Erfindung wird nachfolgend anhand eines in der Zeichnung dargestellten Ausführungsbeispiels näher erläutert. Es zeigen:
- Figur 1: einen Multilayer gemäß der Erfindung in perspektivischer Explosionsdarstellung;
- Figur 2: den Multilayer aus Figur 1 mit aufeinandergelegte Innenlagen; und
- Figur 3: einen Schnitt des Multilayers aus Figur 2 zur Darstellung eines Verfahrensschrittes des erfindungsgemäßen Herstellungsverfahrens.

Die Figuren sind schematisierte, nicht-maßstäbliche und vereinfachte Darstellungen zur Erläuterung des erfindungsgemäßen Verfahrens.

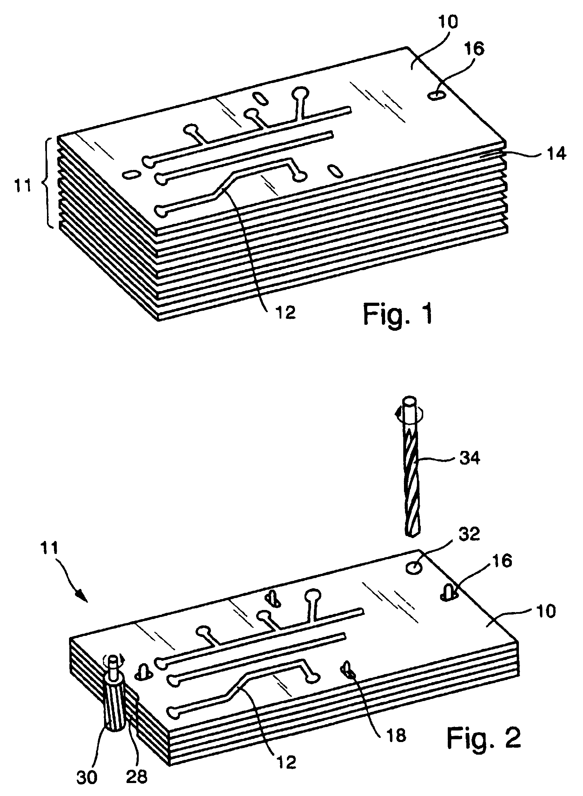

Figur 1 zeigt eine Anzahl von im Ausführungsbeispiel fünf Innenlagen 10, die zur Herstellung eines Multilayers 11 vorgesehen sind. Jede Innenlage 10 ist beidseitig mit in der Zeichnung angedeutet dargestellten Leiterbahnen 12 versehen. Die Leiterbahnen 12 sind in an sich bekannter Weise auf fotochemischem Wege aus einer vollflächig und beidseitig auf jeder Innenlage 10 angebrachten Kupferschicht hergestellt. Zwischen je zwei Innenlagen 10 ist mindestens ein Prepreg 14 (Isolationsfolie) gelegt, das die Leiterbahnen 12 auf einander zugewandten Seiten der Innenlagen 10 elektrisch voneinander isoliert. Die Prepregs14 bestehen aus einem Gewebe, das mit einem Schmelzkleber getränkt ist.

Zur Herstellung des Multilayers 11 werden die Innenlagen 10 mit den zwischengelegten Prepregs 14 aufeinander gelegt (gestapelt), wie in Figur 2 dargestellt. Die Innenlagen 10 werden registriert, also so zueinander verschoben, daß ihre Leiterbahnen 12 in einer vorgesehenen Lage zueinander ausgerichtet sind. Zum Registrieren sind im dargestellten Ausführungsbeispiel die Innenlagen 10 mit vier Registrierlöchern 16 in der Mitte ihrer Ränder versehen. Die Registrierlöcher 16 sind senkrecht zu den Rändern der Innenlagen 10 ausgerichtete Langlöcher, mit denen die Innenlagen 10 auf vier Registrierstifte 18 (Pins) aufgesetzt sind. Die Registrierstifte 18 richten die Innenlagen 10 zueinander aus, wobei die als Langlöcher ausgebildeten Registrierlöcher 16 Temperaturdehnungen der Innenlagen 10 zulassen. Die Registrierlöcher 16 sind in bezug auf die Leiterbahnen 12 ausgerichtet in den Innenlagen 10 angebracht, da es auf die Ausrichtung der Leiterbahnen 12 der verschiedenen Innenlagen 10 ankommt. Eine andere Möglichkeit ist es, die Innenlagen 10 sequentiell mit Hilfe von Videokameras zu registrieren (optische Registrierung, nicht dargestellt).

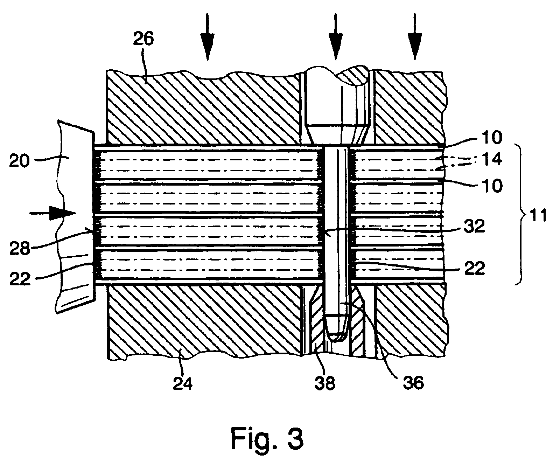

Nach dem Registrieren werden die Innenlagen 10 durch örtlich begrenztes Aufschmelzen der zwischenliegenden Prepregs 14 an mehreren über die Fläche der Innenlagen 10 verteilten Stellen fixiert, also örtlich begrenzt miteinander verbunden. Das Fixieren verhindert ein Verschieben der registrierten Innenlagen 10 beim nachfolgenden Laminieren der Innenlagen 10 zum Multilayer 11, so daß die Leiterbahnen 12 des laminierten Multilayers 11 ihre vorgesehene, durch das Registrieren bewirkte Ausrichtung zueinander aufweisen. Zum Fixieren wird, wie in Figur 3 dargestellt, ein Heizstempel 20 an eine Stirnfläche der Innenlagen 10 angelegt, der die zwischen die Innenlagen 10 gelegten Prepregs 14 örtlich begrenzt aufschmelzt, so daß die Innenlagen 10 durch eine Klebung 22 fixiert sind. Das Kleben ist ein Polymerisationsvorgang, die Innenlagen 10 werden durch Stoffschluß miteinander verbunden. In Figur 3 sind jeweils zwei Prepregs 14 zwischen zwei Innenlagen 10 eingelegt. Zum Fixieren werden die Innenlagen 10 auf eine Auflage 24 aufgelegt und mittels eines Niederhalters 26 aneinander gedrückt. Der klaren Darstellung wegen sind in Figur 3 die Innenlagen 10 mit Abstand voneinander gezeichnet, tatsächlich liegen sie ausschließlich durch die zwischengelegten Prepregs 14 getrennt dicht aufeinander. Durch das Aufschmelzen der den Schmelzkleber aufweisenden Prepregs 14 mittels des Heizstempels 20 an der Stirnseite der Innenlagen 10 wird jedes Prepreg 14 gleich stark erwärmt, was Voraussetzung für eine gute Fixierung auch der inneren Innenlagen 10 ist. Das Fixieren erfolgt sowohl unter Druckbeaufschlagung durch den die Innenlagen 10 auf die Auflage 24 drückenden Niederhalter 26 als auch durch Temperaturbeaufschlagung mittels des Heizstempels 20. Das Fixieren der Innenlagen 10 erfolgt an mindestens zwei, vorzugsweise an mehr als zwei voneinander beabstandeten Stellen des Multilayers 11.

Die Stirnfläche der Innenlagen 10, an der der Heizstempel 10 anliegt, bildet eine allen Innenlagen 10 gemeinsame Freifläche 28. Um eine gleichmäßige Anlage des Heizstempels 20 an allen Innenlagen 10 sowie an allen Prepregs 14 sicherzustellen, kann, wie in Figur 2 angedeutet, beispielsweise mittels eines Fräsers 30 die Stirnfläche der Innenlagen 10 an den Bereichen berarbeitet werden, an denen die Anlage des Heizstempels 20 vorgesehen ist. Das Fräsen oder auch ein sonstiges Trennverfahren stellt eine einheitliche, stufenlose Freifläche für die gleichmäßige Anlage des Heizstempels 20 an allen Innenlagen 10 sicher.

Eine andere Möglichkeit zur Fixierung der registrierten Innenlagen 10 ist in Figur 3 rechts dargestellt. Es werden über die Fläche des Multilayers 11 verteilt mehrere Löcher 32 durch alle Innenlagen 10 durchgehend beispielsweise mittels eines Bohrers 34, wie in Figur 2 an einer Stelle des Multilayers 11 dargestellt, angebracht. Die Löcher 32 können beispielsweise auch gestanzt, mit Laser gebohrt oder auf sonstige Weise hergestellt werden. Durch die Löcher 32 wird, wie in Figur 3 dargestellt, ein Heizstift 36 gesteckt, dessen Ende in einem rohrförmigen Gegenhalter 38 aufgenommen wird. Mit dem Heizstift 36 werden Innenlagen 10 gegeneinander gedrückt und die Prepregs 14 im Bereich des Lochs 32 aufgeschmolzen und dadurch die Innenlagen 10 fixiert. Auch hier werden die Innenlagen 10 durch einen Polymerisationsvorgang im Bereich des Lochs 32 örtlich begrenzt miteinander verklebt (Klebung 22). Eine Wandung des Lochs 32 bildet wiederum eine Freifläche, die eine gleichmäßige Anlage des Heizstifts 36 an allen Innenlagen 10 und an allen Prepregs 14 sicherstellt, die Voraussetzung für eine gute Fixierung aller Innenlagen 10, insbesondere auch der inneren Innenlagen 10, ist.

Das Fixieren der Innenlagen kann beispielsweise auch durch Aufschmelzen des Schmelzklebers der Prepegs 14 mit einem Laser erfolgen, wozu der Laser auf die Stirnfläche des Multilayers 11 gerichtet oder das Loch 32 mit dem Laser gebohrt wird. In letzterem Fall wird der Schmelzkleber der Prepregs 14 beim Bohren des Lochs 32 im Lochwandbereich aufgeschmolzen und die Innenlagen 10 dadurch fixiert.

Im Anschluß an das Fixieren werden die Innenlagen 10 in ein nicht dargestelltes, heizbares Preßwerkzeug eingelegt und unter Temperaturbeaufschlagung in an sich bekannter Weise miteinander verpreßt, wobei die Innenlagen 10 durch Aufschmelzen der Prepregs 14 und anschließendes Polymerisieren zum Multilayer 11 lamieniert, d. h. vollflächig miteinander verbunden werden.

Im Anschluß an das Laminieren ist es möglich, eine sog. Außenlage auf die Ober- und/oder die Unterseite des Multilayers 11 aufzubringen. Dazu wird eine weiteres Prepreg sowie eine über die gesamte Fläche des Multilayers 11 durchgehende, die Außenlage bildende Kupferfolie (Kupferschicht) aufgelegt und unter Temperaturbeaufschlagung mit dem Multilayer 11 verbunden (nicht dargestellt). Aus dieser Kupferfolie werden in an sich bekannter Weise auf fotochemischem Wege Leiterbahnen in einer zusätzlichen Ebene hergestellt.

Das Laminieren der Innenlagen 10 zum Multilayer 11 erfolgt im Vakuum.

## Patentansprüche

1. Verfahren zur Herstellung eines Multilayers mit mindestens zwei Innenlagen, die aufeinandergelegt und und registriert werden, wobei die Innenlagen unter örtlich begrenzter Temperaturbeaufschlagung an einer oder mehreren Stellen des Multilayers fixiert werden, **dadurch gekennzeichnet**, daß die Temperaturbeaufschlagung örtlich begrenzt an einer oder mehreren von einer Oberseite zu einer Unterseite des Multilayers (11) über alle Innenlagen (10) durchgehenden Freifläche (28, 32) erfolgt.

2. Verfahren nach Anspruch 1, **dadurch gekennzeichnet**, daß die Innenlagen (10) während der Temperaturbeaufschlagung aneinander gedrückt werden.

3. Verfahren nach Anspruch 1, **dadurch gekennzeichnet**, daß beim Aufeinanderlegen der Innenlagen (10) zwischen zwei Innenlagen (10) eine Klebstoff aufweisende Isolationsschicht (14) verbracht wird.

4. Verfahren nach Anspruch 3, **dadurch gekennzeichnet**, daß der Klebstoff ein Schmelzkleber ist.

5. Verfahren nach Anspruch 3, **dadurch gekennzeichnet**, daß die Isolationsschicht ein Prepreg (14) ist.

6. Verfahren nach Anspruch 1, **dadurch gekennzeichnet**, daß die Freifläche (28, 32) zur Temperaturbeaufschlagung der Innenlagen (10) durch ein Trennverfahren hergestellt wird.

7. Verfahren nach Anspruch 1, **dadurch gekennzeichnet**, daß die Innenlagen (10) nach dem Fixieren durch die örtlich begrenzte Temperaturbeaufschlagung an der/den Freiflächen durch eine im wesentlichen vollflächige Temperatur- und/oder Druckbeaufschlagung zum Multilayer (11) laminiert werden.

8. Verfahren nach Anspruch 1, **dadurch gekennzeichnet**, daß auf die Ober- und/oder Unterseite des Multilayers (12) eine weitere Isolationsschicht und auf dieser eine elektrisch leitende Schicht als Außenlage aufgebracht wird.
